# EUROPÄISCHE PATENTSCHRIFT

(11) **EP 2 801 832 B1**
(45) Veröffentlichungstag und Bekanntmachung des Hinweises auf die Patenterteilung: **27.03.2024**
(21) Anmeldenummer: 14155684.5
(22) Anmeldetag: 19.02.2014
(51) Int. Cl.: G01R 15/20

(54) **Vorrichtung zur Strommessung**
Device for current measurement
Dispositif de mesure du courant

(30) Priorität: 07.05.2013 CH 9242013; 17.06.2013 CH 11302013
(43) Veröffentlichungstag der Anmeldung: 12.11.2014
(73) Patentinhaber: Melexis Technologies NV, 3980 Tessenderlo (BE)
(72) Erfinder: Racz, Robert, 6300 Zug (CH); Ackermann, Mathieu, 1006 Lausanne (CH); Chen, Jian, Heist op den Berg 2220 (BE)
(74) Vertreter: Winger

(56) Entgegenhaltungen:
- CH-A1- 703 903
- US-A1- 2004 155 644
- US-A1- 2007 200 551

## Beschreibung

Die Erfindung betrifft eine Vorrichtung zur Strommessung.

Stromsensoren gibt es in vielen Ausführungen und Varianten. Stromsensoren, die das vom Strom erzeugte Magnetfeld erfassen, in einem herkömmlichen IC Gehäuse verpackt sind und bei denen der Stromleiter, durch den der zu messende Strom fliesst, durch das Gehäuse geführt ist, sind beispielsweise bekannt aus EP 1443332, WO 2005026749, WO 2006130393, DE 102009054892, US 2004/155644 und CH 703903. Solche Stromsensoren enthalten einen Stromleiter, der als ein Teil eines Leadframes ausgebildet ist, das für die Montage und die Herstellung der elektrischen Anschlüsse verwendet wird, und einen auf dem Leadframe montierten Halbleiterchip, der mindestens einen Magnetfeldsensor und die für dessen Betrieb und die Verarbeitung seines Ausgangssignals nötige Elektronik aufweist.

Darüber hinaus sind auch in einem herkömmlichen IC Gehäuse verpackte Stromsensoren bekannt, beispielsweise aus JP 2003302428, die auf einer Leiterplatte oberhalb einer Leiterbahn montiert sind und den durch die Leiterbahn fliessenden Strom messen. Eine weitere Klasse von Stromsensoren umfasst einen U-förmig ausgebildeten Stromleiter (bus bar) und ein darin einpassbares IC Gehäuse, in dem ein Magnetfelddetektor verpackt ist. Ein Beispiel hierfür ist die veröffentliche Anmeldung US 2007200551 A1 (Muraki Hitoshi et al) 12 Aug. 2004. In diesen Stromsensoren fällt eine Positionierung des Magnetfelddetektors relativ zu einem oberen und parallel dazu verlaufendem unteren stromführenden Segment des Stromleiters genau und stabiel aus.

Die Erfindung besteht in den im Anspruch 1 angegebenen Merkmalen. Vorteilhafte Ausgestaltungen ergeben sich aus den abhängigen Ansprüchen.

Die Erfindung wird nachfolgend anhand von Ausführungsbeispielen und anhand der Zeichnung näher erläutert.
- Fig. 1 und 2: zeigen im Querschnitt und in Aufsicht ein Ausführungsbeispiel einer erfindungsgemässen Vorrichtung zur Strommessung,
- Fig. 3 und 4: zeigen im Querschnitt weitere Ausführungsbeispiele einer erfindungsgemässen Vorrichtung zur Strommessung, und
- Fig. 5: eine erfindungsgemässe Vorrichtung, die zusätzlich eine magnetische Abschirmung aufweist.

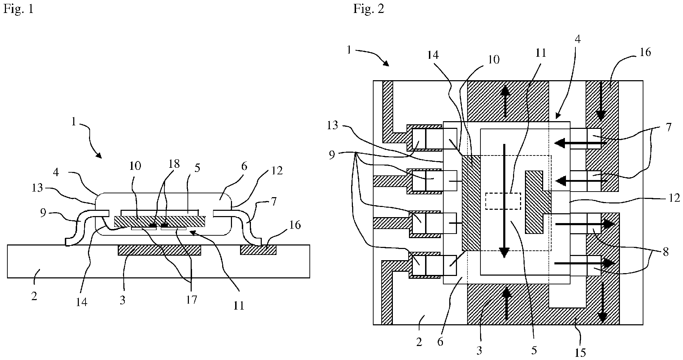

Die Fig. 1 und 2 zeigen im Querschnitt und in Aufsicht ein Ausführungsbeispiel einer erfindungsgemässen Vorrichtung 1 zur Strommessung. Die Vorrichtung 1 umfasst ein Substrat 2 mit einem ersten Stromleiter 3 und einen Stromsensor 4 mit einem zweiten Stromleiter 5. Der Stromsensor 4 ist in einem IC Gehäuse 6, beispielsweise in einem SOIC-8 oder SOIC-16 Gehäuse, verpackt und oberhalb des ersten Stromleiters 3 auf dem Substrat 2 montiert. Der Stromsensor 4 umfasst den zweiten Stromleiter 5 mit angeformten ersten und zweiten elektrischen Anschlussbeinchen 7 und 8, durch die der zu messende Strom zu- und abgeführt wird, und dritte elektrische Anschlussbeinchen 9, sowie einen Halbleiterchip 10, der auf dem zweiten Stromleiter 5 auf der dem Substrat 2 zugewandten Seite montiert ist. Der Halbleiterchip 10 weist eine aktive Oberfläche mit einem Magnetfeldsensor 11 und elektronischen Schaltkreisen für den Betrieb des Magnetfeldsensors auf. Die ersten und zweiten Anschlussbeinchen 7 und 8 ragen an einer ersten Seitenwand 12 des Gehäuses 6 und die dritten Anschlussbeinchen 9 an einer der ersten Seitenwand 12 gegenüberliegenden Seitenwand 13 des Gehäuses 6 aus dem Gehäuse 6 heraus und sind zum Substrat 2 hin abgebogen. Elektrische Anschlüsse des Halbleiterchips 10 sind über Bonddrähte 14 mit den dritten Anschlussbeinchen 9 verbunden. Der Stromsensor 4 ist derart ausgerichtet und auf dem Substrat 2 montiert, dass der erste Stromleiter 3 und der zweite Stromleiter 5 parallel zueinander verlaufen und im wesentlichen im Abstand zueinander übereinander liegen. Die beiden Stromleiter 3 und 5 sind elektrisch miteinander verbunden und zwar derart, dass der zu messende Strom in den beiden Stromleitern 3 und 5 in entgegengesetzte Richtungen fliesst. Der Magnetfeldsensor ist empfindlich auf diejenige Komponente des Magnetfeldes, die parallel zur aktiven Oberfläche des Halbleiterchips 10, und somit auch parallel zur Oberfläche des Substrats 2, und senkrecht zu den beiden Stromleitern 3 und 5 verläuft.

Das Substrat 2 weist mehrere Leiterbahnen auf, die dazu dienen, den zu messenden Strom zu dem Stromsensor 4 und durch den ersten Stromleiter 3 zu führen, den Stromsensor 4 mit elektrischer Energie zu versorgen und das Ausgangssignal des Stromsensors 4 an eine geeignete Stelle zu leiten. Der erste Stromleiter 3 ist Teil einer solchen Leiterbahn 15, die zusätzlich so geformt ist, dass die Anschlussbeinchen 8 die Leiterbahn 15 kontaktieren. Der zu messende Strom wird durch eine Leiterbahn 16 zu den ersten Anschlussbeinchen 7 geführt, fliesst durch den zweiten Stromleiter 5 im Stromsensor 4 und dann durch die Anschlussbeinchen 8 zur Leiterbahn 15 und durch den ersten Stromleiter 3. Das magnetische Feld, das am Ort des Magnetfeldsensors erzeugt wird, wenn der Strom durch den ersten Stromleiter 3 fliesst, und das magnetische Feld, das am Ort des Magnetfeldsensors erzeugt wird, wenn der Strom durch den zweiten Stromleiter 5 fliesst, zeigen in die gleiche Richtung und addieren sich somit.

Der Magnetfeldsensor ist wie dargestellt bevorzugt ein Magnetfeldsensor, wie er aus der EP 772046 bekannt ist. Ein solcher Magnetfeldsensor umfasst zwei Magnetfeldkonzentratoren 17, die durch einen schmalen Spalt getrennt sind, und zwei horizontale Hallelemente 18 (oder Cluster von Hallelementen), die beidseitig des Spalts unterhalb des Randes der Magnetfeldkonzentratoren 17 angeordnet sind, oder ein vertikales Hallelement, das im Spalt zwischen den Magnetfeldkonzentratoren 17 angeordnet ist. Der Magnetfeldsensor kann aber auch ein AMR (anisotropic magnetoresistive sensor) oder ein GMR (giant magnetoresistive sensor) oder ein Fluxgate Sensor oder ein anderer magnetischer Sensor sein.

Die erfindungsgemässe Vorrichtung zur Strommessung zeichnet sich dadurch aus, dass der zu messende Strom erstens durch einen Stromleiter fliesst, der Teil eines Stromsensors ist, und zweitens durch einen Stromleiter, der unterhalb des Stromsensors angeordnet ist, wobei die beiden Stromleiter parallel zueinander verlaufen. Das von dem zu messenden Strom erzeugte Magnetfeld wird dadurch am Ort des Magnetfeldsensors vergrössert.

Es ist auch möglich, mindestens einen weiteren Stromleiter 19 vorzusehen, der parallel zu dem ersten Stromleiter 3 verläuft und neben oder unterhalb des ersten Stromleiters 3 angeordnet ist. Der mindestens eine weitere Stromleiter 19 ist derart in Reihe mit dem ersten Stromleiter 3 geschaltet, dass der zu messende Strom in der gleichen Richtung durch den ersten Stromleiter 3 und den mindestens einen weiteren Stromleiter 19 fliesst. Die dazu nötigen Verbindungen sind so um den Stromsensor 4 herum geführt, dass sie am Ort des Magnetfeldsensors 11 kein bzw. ein vergleichsweise sehr geringes Magnetfeld erzeugen.

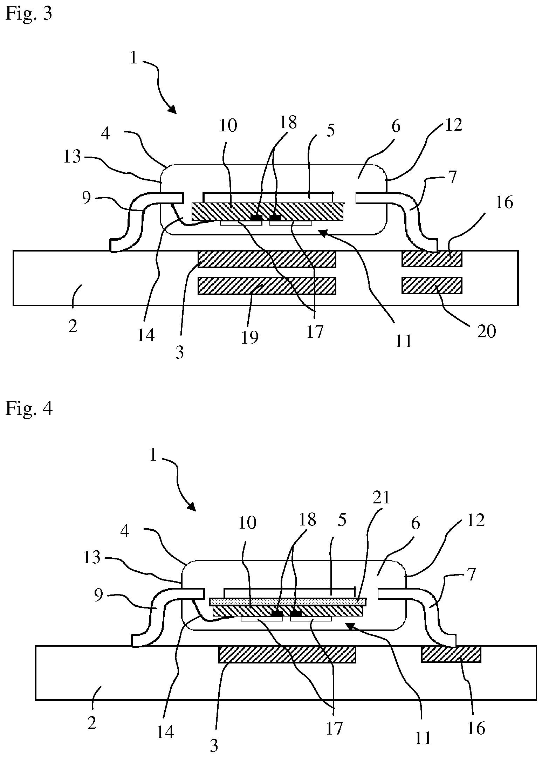

Das Substrat 2 ist insbesondere eine Leiterplatte. Heutzutage weisen solche Leiterplatten oft mehrere Metallisierungsebenen auf. In diesem Fall kann es sinnvoll sein, in mindestens einer weiteren Metallisierungsebene einen weiteren Stromleiter 19 vorzusehen, der parallel zu dem ersten Stromleiter 3 verläuft. Der mindestens eine weitere Stromleiter 19 und der erste Stromleiter 3 sind in Reihe hintereinander geschaltet und derart durch Leiterbahnen 20 miteinander verbunden, dass der zu messende Strom in dem ersten Stromleiter 3 und in allen weiteren Stromleitern 19 in die gleiche Richtung fliesst. Mit anderen Worten, der erste Stromleiter 3 und die weiteren Stromleiter 19 bilden eine Spule. Eine derartige Vorrichtung zur Strommessung ist im Querschnitt in der Fig. 3 dargestellt.

Die Fig. 4 zeigt im Querschnitt eine erfindungsgemässe Vorrichtung 1 zur Strommessung, bei der zwischen dem Halbleiterchip 10 und dem zweiten Stromleiter 5 des Stromsensors 4 eine keramische Platte 21 angeordnet ist, die als elektrischer Isolator dient. Die keramische Platte 21 überragt den Halbleiterchip 10 auf allen vier Seiten um mindestens 0.1 mm, bevorzugt um mindestens 0.4 mm. Die Dicke der keramischen Platte 21 beträgt typischerweise 0.4 mm oder mehr. Auf diese Weise wird eine hohe Spannungsfestigkeit zwischen dem Halbleiterchip 10 und dem zweiten Stromleiter 5 erreicht.

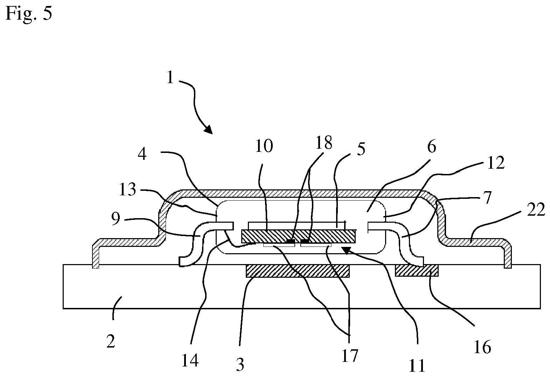

Auf der dem Halbleiterchip 10 gegenüberliegenden Seite des zweiten Stromleiters 5 kann fakultativ eine magnetische Abschirmung 22 angebracht sein. Ein solches Ausführungsbeispiel ist in der Fig. 5 gezeigt. Die magnetische Abschirmung 22 dient dazu, den Magnetfeldsensor 11 gegen ein parallel zur Oberfläche des Halbleiterchips 10, und somit auch parallel zur Oberfläche des Substrats 2, und senkrecht zu den beiden Stromleitern 3 und 5 verlaufendes Magnetfeld abzuschirmen. Die Abschirmung 22 kann in das Gehäuse 6 des Stromsensors 4 integriert oder ein separates, ferromagnetisches Bauteil sein.

Die erfindungsgemässe Vorrichtung 1 zur Strommessung kann in modifizierter Form auch dazu verwendet werden, die Differenz von zwei Strömen zu messen. Die Modifizierung besteht darin, dass erste Stromleiter 3 auf dem Substrat 2 und der zweite Stromleiter 5 des Stromsensors 4 elektrisch nicht miteinander verbunden sind. Im Betrieb fliesst der erste zu erfassende Strom in einer vorbestimmten Richtung durch den ersten Stromleiter 3 und der zweite zu erfassende Strom fliesst in der gleichen Richtung durch den zweiten Stromleiter 5. Der Magnetfeldsensor 11 erfasst die Differenz des von dem ersten Strom erzeugten Magnetfelds und des von dem zweiten Strom erzeugten Magnetfelds, da diese beiden Magnetfelder am Ort des Magnetfeldsensors 11 in entgegengesetzte Richtungen zeigen. Damit die Differenz der beiden Magnetfelder auch der Differenz der beiden Ströme entspricht, muss am Ort des Magnetfeldsensors 11 bei gleicher Stärke der beiden Ströme das von dem ersten Strom erzeugte Magnetfeld betragsmässig gleich stark sein wie das von dem zweiten Strom erzeugte Magnetfeld. Dies kann erreicht werden auf folgende Weisen, die je nach Möglichkeit einzeln oder in Kombination angewendet werden:
- Anordnen des ersten Stromleiters 3 derart auf oder in dem Substrat 2, dass der Abstand des ersten Stromleiters 3 zum Magnetfeldsensor 11 gleich gross ist wie der Abstand des zweiten Stromleiters 5 zum Magnetfeldsensor 11. Die beiden Stromleiter 3 und 5 haben auch die gleiche Breite und liegen über einander.
- Aufeinander Abstimmen von Breite des ersten Stromleiters 3 und Abstand des ersten Stromleiters 3 zum Magnetfeldsensor 11 und von Breite des zweiten Stromleiters 5 und Abstand des zweiten Stromleiters 5 zum Magnetfeldsensor 11.

## Patentansprüche

1. Vorrichtung zur Strommessung, umfassend
ein Substrat (2) mit einem ersten Stromleiter (3), der für die Aufname eines ersten zu messenden Stroms geeignet ist, und
einen in ein IC Gehäuse (6) verpackten Stromsensor (4), der einen zweiten, sich innerhalb des Gehäuses (6) erstreckenden und mit angeformten ersten und zweiten elektrischen Anschlussbeinchen (7, 8) ausgebildeten Stromleiter (5) sowie dritte elektrische Anschlussbeinchen (9) aufweist, wobei
das Gehäuse (6) oberhalb des ersten Stromleiters (3) derart auf dem Substrat (2) montiert ist, dass der zweite Stromleiter (5) oberhalb und parallel zum ersten Stromleiter (3) verläuft und die ersten, zweiten und dritten Anschlussbeinchen (7, 8) zum Substrat (2) hin abgebogen und auf dem Substrat (2) befestigt sind,
der Stromsensor (4) einen Halbleiterchip (10) aufweist, der auf einer dem Substrat (2) zugewandten Seite des zweiten Stromleiters (5) montiert ist und eine zwischem dem ersten und zweiten Stromleiter (3, 5) positionierte aktive Oberfläche mit einem Magnetfeldsensor (11) und elektronischen Schaltkreisen für den Betrieb des Magnetfeldsensors (11) besitzt,
die ersten und zweiten Anschlussbeinchen (7, 8) an einer ersten Seitenwand (12) des Gehäuses (6) aus dem Gehäuse (6) herausragen und für die Aufnahme eines zweiten zu messenden, vom Substrat (2) ausgehenden Stroms in den zweiten Stromleiter (5) geeignet sind,
die dritten Anschlussbeinchen (9) an einer der ersten Seitenwand (12) gegenüberliegenden Seitenwand (13) des Gehäuses (6) aus dem Gehäuse (6) herausragen und über Bonddrähte (14) mit elektrischen Anschlüssen des Halbleiterchips (10) verbunden sind,
der Magnetfeldsensor (11) auf eine parallel zur aktiven Oberfläche des Halbleiterchips (10) und senkrecht zu dem zweiten Stromleiter (5) verlaufende Komponente des Magnetfeldes empfindlich ist.

2. Vorrichtung nach Anspruch 1, **dadurch gekennzeichnet, dass** der erste zu messende Strom und der zweite zu messende Strom der gleiche Strom sind, und dass der zweite Stromleiter (5) über die ersten oder zweiten Anschlussbeinchen (7, 8) elektrisch derart mit dem ersten Stromleiter (3) in Reihe geschaltet ist, dass der zu messende Strom durch den ersten Stromleiter (3) und in entgegengesetzter Richtung durch den zweiten Stromleiter (5) fliesst.

3. Vorrichtung nach Anspruch 2, **dadurch gekennzeichnet, dass** das Substrat (2) mindestens einen weiteren Stromleiter (19) aufweist, der derart in Reihe mit dem ersten Stromleiter (3) geschaltet ist, dass der zu messende Strom in der gleichen Richtung durch den ersten Stromleiter (3) und den mindestens einen weiteren Stromleiter (19) fliesst.

4. Vorrichtung nach Anspruch 1, **dadurch gekennzeichnet, dass** die Vorrichtung derart konfiguriert ist, dass im Betrieb der erste zu messende Strom in einer vorbestimmten Richtung durch den ersten Stromleiter (3) und der zweite zu messende Strom in der gleichen Richtung durch den zweiten Stromleiter (5) fliesst, so dass das von dem ersten Strom erzeugte Magnetfeld und das von dem zweiten Strom erzeugte Magnetfeld am Ort des Magnetfeldsensors (11) in entgegengesetzte Richtungen zeigen, und dass Breite und Abstand des ersten Stromleiters (3) zum Magnetfeldsensor (11) und Breite und Abstand des zweiten Stromleiters (5) zum Magnetfeldsensor (11) derart aufeinander abgestimmt sind, dass das von dem ersten Strom erzeugte Magnetfeld und das von dem zweiten Strom erzeugte Magnetfeld bei gleicher Stärke der beiden Ströme am Ort des Magnetfeldsensors (11) betragsmässig gleich stark sind.

5. Vorrichtung nach einem der Ansprüche 1 bis 4, **dadurch gekennzeichnet, dass** auf der dem Halbleiterchip (10) gegenüberliegenden Seite des zweiten Stromleiters (5) eine magnetische Abschirmung (22) angebracht ist.

6. Vorrichtung nach einem der Ansprüche 1 bis 5, **dadurch gekennzeichnet, dass** der Magnetfeldsensor mindestens einen Magnetfeldkonzentrator (17) und mindestens ein Hallelement (18) aufweist, wobei das Hallelement (18) entweder ein horizontales Hallelement ist, das im Bereich des Randes des Magnetfeldkonzentrators (17) unterhalb dem Magnetfeldkonzentrator (17) angeordnet ist, oder ein vertikales Hallelement ist, das im Bereich des Randes des Magnetfeldkonzentrators (17) neben dem Magnetfeldkonzentrator (17) angeordnet ist.

7. Vorrichtung nach einem der Ansprüche 1 bis 5, **dadurch gekennzeichnet, dass** der Magnetfeldsensor (11) ein AMR, GMR oder Fluxgate Sensor ist.

8. Vorrichtung nach einem der Ansprüche 1 bis 7, **dadurch gekennzeichnet, dass** zwischen dem Halbleiterchip (10) und dem zweiten Stromleiter (5) des Stromsensors (4) eine keramische Platte (21) angeordnet ist, die als elektrischer Isolator dient.

9. Vorrichtung nach Anspruch 8, **dadurch gekennzeichnet, dass** die keramische Platte (21) den Halbleiterchip (10) auf allen vier Seiten um mindestens 0.1 mm überragt.

10. Vorrichtung nach Anspruch 8, **dadurch gekennzeichnet, dass** die keramische Platte (21) den Halbleiterchip (10) auf allen vier Seiten um mindestens 0.4 mm überragt.

## Claims

1. Device for measuring current, comprising
a substrate (2) with a first current conductor (3), which is suitable for recording a first current to be measured, and
a current sensor (4) encased in an IC housing (6), which current sensor comprises a second current conductor (5) extending inside the housing (6) and with molded first and second electric terminal leads (7, 8) and also third electric terminal leads (9), wherein
the housing (6) is mounted above the first current conductor (3) on the substrate (2), such that the second current conductor (5) extends above and parallel to the first current conductor (3) and the first, second and third terminal leads (7, 8) are bent towards the substrate (2) and fixed onto the substrate (2),
the current sensor (4) comprises a semiconductor chip (10), which is mounted on a side of the second current conductor (5) facing the substrate (2) and an active surface positioned between the first and second current conductors (3, 5) with a magnetic field sensor (11) and electronic circuits for the operation of the magnetic field sensor (11),
the first and second terminal leads (7, 8) on a first side wall (12) of the housing (6) protrude from the housing (6) and are suitable for recording a second current to be measured coming from the substrate (2) into the second current conductor (5),
the third terminal leads (9) protrude from the housing (6) on a side wall (13) of the housing (6) opposite the first side wall (12) and are connected via bond wires (14) to electric terminals of the semiconductor chip (10),
the magnetic field sensor (11) is sensitive to a component of the magnetic field extending parallel to the active surface of the semiconductor chip (10) and perpendicular to the second current conductor (5).

2. Device according to claim 1, **characterized in that** the first current to be measured and the second current to be measured are the same current, and **in that** the second current conductor (5) is electrically connected in series to the first current conductor (3) via the first or second terminal leads (7, 8), such that the current to be measured flows through the first current conductor (3) and in opposite direction through the second current conductor (5).

3. Device according to claim 2, **characterized in that** the substrate (2) has at least one further current conductor (19), which is connected in series with the first current conductor (3) such that the current to be measured flows in the same direction through the first current conductor (3) and the at least one further current conductor (19).

4. Device according to claim 1, **characterized in that** the device is configured such that in operation the first current to be measured flows in a predetermined direction through the first current conductor (3) and the second current to be measured flows in the same direction through the second current conductor (5), so that the magnetic field generated by the first current and the magnetic field generated by the second current point in opposite directions at the location of the magnetic field sensor (11), and **in that** width and distance of the first current conductor (3) from the magnetic field sensor (11) and width and distance of the second current conductor (5) from the magnetic field sensor (11) are adjusted to one another in such a way that the magnetic field generated by the first current and the magnetic field generated by the second current are equally strong in terms of their amount when both currents have the same intensity at the location of the magnetic field sensor (11).

5. Device according to any one of claims 1 to 4, **characterized in that** a magnetic shield (22) is attached on the side of the second current conductor (5) opposite the semiconductor chip (10).

6. Device according to any one of claims 1 to 5, **characterized in that** the magnetic field sensor comprises at least one magnetic field concentrator (17) and at least one Hall element (18), wherein the Hall element (18) is either a horizontal Hall element, which is arranged in the region of the edge of the magnetic field concentrator (17) below the magnetic field concentrator (17), or a vertical Hall element which is arranged in the region of the edge of the magnetic field concentrator (17) next to the magnetic field concentrator (17).

7. Device according to any one of claims 1 to 5, **characterized in that** the magnetic field sensor (11) is an AMR, GMR or fluxgate sensor.

8. Device according to any one of claims 1 to 7, **characterized in that** a ceramic plate (21), which is used as an electric insulator, is arranged between the semiconductor chip (10) and the second current conductor (5) of the current sensor (4).

9. Device according to claim 8, **characterized in that** the ceramic plate (21) protrudes beyond the semiconductor chip (10) on all four sides by at least 0.1 mm.

10. Device according to claim 8, **characterized in that** the ceramic plate (21) protrudes beyond the semiconductor chip (10) on all four sides by at least 0.4 mm.

## Revendications

1. Dispositif de mesure de courant, comprenant
un substrat (2) avec un premier conducteur (3), qui est adapté pour l'enregistrement d'un premier courant à mesurer, et
un détecteur de force (4) enveloppé dans un boîtier de circuit intégré (6), qui présente un deuxième conducteur (5) s'étendant dans le boîtier (6) et conçu avec des premières et deuxièmes pattes de raccordement électriques (7, 8) façonnées, ainsi que des troisièmes pattes de raccordement électriques (9), dans lequel
le boîtier (6) est monté au-dessus du premier conducteur (3) sur le substrat (2) de telle manière que le deuxième conducteur (5) s'étend au-dessus et parallèlement au premier conducteur (3) et les premières, deuxièmes et troisièmes pattes de raccordement (7, 8) sont tournées vers le substrat (2) et fixées au substrat (2),
le détecteur de force (4) présente une puce semi-conductrice (10), qui est montée sur l'un des côtés orientés vers le substrat (2) du deuxième conducteur (5) et possède une surface active positionnée entre le premier et le deuxième conducteur (3, 5) avec un capteur de champ magnétique (11) et des circuits électroniques pour le fonctionnement du capteur de champ magnétique (11),
les premières et deuxièmes pattes de raccordement (7, 8) font saillie au niveau d'une première paroi latérale (12) du boîtier (6) depuis le boîtier (6) et sont adaptées pour l'enregistrement d'un second courant sortant du substrat (2) à mesurer dans le deuxième conducteur (5),
les troisièmes pattes de raccordement (9) font saillie au niveau d'une paroi latérale (13) opposée à la première paroi latérale (12) du boîtier (6) depuis le boîtier (6) et sont reliées par le biais de fils de connexion (14) à des bornes électriques de la puce semi-conductrice (10),
le capteur de champ magnétique (11) est sensible à une composante du champ magnétique s'étendant parallèlement à la surface active de la puce semi-conductrice (10) et perpendiculairement au deuxième conducteur (5).

2. Dispositif selon la revendication 1, **caractérisé en ce que** le premier courant à mesurer et le second courant à mesurer représentent le même courant, et **en ce que** le deuxième conducteur (5) est monté en série électriquement par le biais des premières ou deuxièmes pattes de raccordement (7, 8) avec le premier conducteur (3) de telle manière que le courant à mesurer traverse le premier conducteur (3) et en sens inverse traverse le deuxième conducteur (5).

3. Dispositif selon la revendication 2, **caractérisé en ce que** le substrat (2) présente au moins un autre conducteur (19), qui est monté en série avec le premier conducteur (3) de telle manière que le courant à mesurer traverse le premier conducteur (3) dans le même sens et traverse le au moins un autre conducteur (19).

4. Dispositif selon la revendication 1, **caractérisé en ce que** le dispositif est configuré de telle manière que lors du fonctionnement le premier courant à mesurer traverse le premier conducteur (3) dans un sens prédéterminé et le second courant à mesurer traverse le deuxième conducteur (5) dans le même sens, de sorte que le champ magnétique produit par le premier courant et le champ magnétique produit par le second courant à l'emplacement du capteur de champ magnétique (11) pointent dans des sens opposés, et **en ce que** la largeur et la distance du premier conducteur (3) par rapport au capteur de champ magnétique (11) et la largeur et la distance du deuxième conducteur (5) par rapport au capteur de champ magnétique (11) sont accordées les unes aux autres de telle manière que le champ magnétique produit par le premier courant et le champ magnétique produit par le second courant sont de même intensité en termes de valeurs en cas d'intensité identiques des deux courants à l'emplacement du capteur de champ magnétique (11).

5. Dispositif selon l'une quelconque des revendications 1 à 4, **caractérisé en ce qu'**un blindage magnétique (22) est fixé sur le côté opposé à la puce semi-conductrice (10) du deuxième conducteur (5).

6. Dispositif selon l'une quelconque des revendications 1 à 5, **caractérisé en ce que** le capteur de champ magnétique présente au moins un concentrateur de champ magnétique (17) et au moins un élément Hall (18), dans lequel l'élément Hall (18) est soit un élément Hall horizontal, qui est disposé dans la zone bordant le concentrateur de champ magnétique (17) en dessous du concentrateur de champ magnétique (17), soit est un élément Hall vertical, qui est disposé dans la zone bordant le concentrateur de champ magnétique (17) à proximité du concentrateur de champ magnétique (17).

7. Dispositif selon l'une quelconque des revendications 1 à 5, **caractérisé en ce que** le capteur de champ magnétique (11) est un capteur AMR, GMR ou Fluxgate.

8. Dispositif selon l'une quelconque des revendications 1 à 7, **caractérisé en ce qu'**une plaque céramique (21) est disposée entre la puce semi-conductrice (10) le deuxième conducteur (5) du détecteur de force (4), qui sert d'isolant électrique.

9. Dispositif selon la revendication 8, **caractérisé en ce que** la plaque céramique (21) dépasse d'au moins 0,1 mm les quatre côtés de la puce semi-conductrice (10).

10. Dispositif selon la revendication 8, **caractérisé en ce que** la plaque céramique (21) dépasse d'au moins 0,4 mm les quatre côtés de la puce semi-conductrice (10).
